Europäisches Patentamt

European Patent Office

Office européen des brevets

(11) Publication number: **0 173 306**
A1

# EUROPEAN PATENT APPLICATION

(21) Application number: 85110810.0

(22) Date of filing: 28.08.85

(51) Int. Cl.⁴: **H 04 N 5/14,** H 04 N 9/64

(30) Priority: 31.08.84 JP 180529/84

(43) Date of publication of application: 05.03.86
Bulletin 86/10

(84) Designated Contracting States: DE FR GB

(71) Applicant: HITACHI, LTD., 6, Kanda Surugadai 4-chome
Chiyoda-ku, Tokyo 100 (JP)

(72) Inventor: Noda, Masaru, 1-19, Fuzimigaoka
Ninomiya-cho, Naka-Gun Kanagawa (JP)

(74) Representative: Altenburg, Udo, Dipl.-Phys. et al, Patent-
und Rechtsanwälte
Bardehle-Pagenberg-Dost-Altenburg-Frohwitter &
Partner Postfach 86 06 20, D-8000 München 86 (DE)

(54) Video signal processing circuit.

(57) In a video camera in which the video signals of two
scanning lines adjacent with each other in vertical direction
are read out simultaneously, the vertical edges in the video
signal are detected (1) and, in reponse to the result of detec-
tion, the disturbance components arising at the vertical
edge parts are eliminated (2).

HITACHI, LTD.                - 1 -
6, Kanda Surugadai 4-chome              N 6489-EP    ti
Chiyoda-ku, Tokyo, Japan

Description

1 TITLE OF THE INVENTION

VIDEO SIGNAL PROCESSING CIRCUIT

BACKGROUND OF THE INVENTION

The present invention relates to a video signal processing circuit, especially to a video signal processing circuit appropriate to a video camera with a solid state imager.

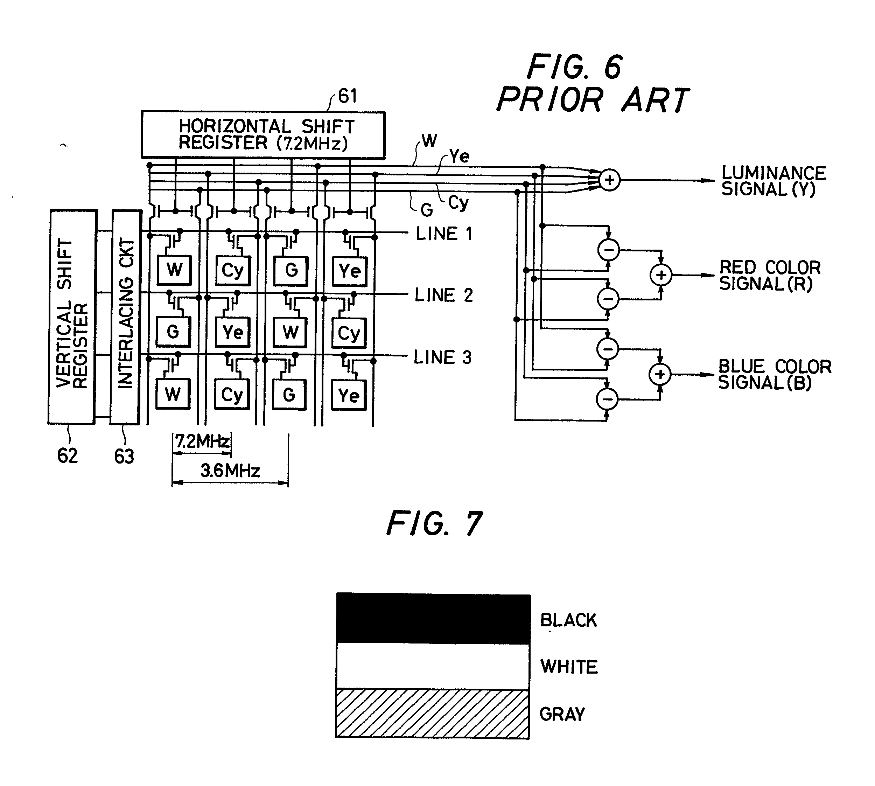

Recently color video cameras with a solid state imager have been developed actively and as one representative example of them, "Solid State Color Camera with Single-Chip Mos Imager" described in Technical Report of the Institute of Television, Vol 4, No. 41, pp 1-6 (1981.Feb.) is known. The imager of this camera and its peripheral circuits are shown in Fig. 6. This imager consists of four kinds of picture elements that are the elements with all color transmission filters (W), with cyanic color transmission filters (Cy), with green color transmission filters (G) and with yellow color transmission filters (Ye). The horizontal pitch corresponds to 7.2 MHz in the frequency of the signal obtained by scanning of these elements. The method of scanning picture elements in such as that the vertical scanning are done for every two lines by the vertical scanning shiftregister 62 and the interlacing circuit 63, for example, the first scanning is done for the first and second lines, the second scanning is for the third and fourth lines, the third scanning is for the fifth and sixth lines and so on. This is referred to the two line simultaneously read out method. The horizontal scannings are done by the holizontal scanning shiftregister 61 in 7.2 MHz in order of the arrangement of picture elements in holizontal direction. The luminance signal Y and two color signals R and B are obtained by addition and subtraction of four kinds of signals (these are referred to as W,Cy, G and Ye respectively) corresponding to each picture element as shown in the figure. Particularly, since the signal Y is obtained by addition of these four signals, the signal Y has a following property.

Observing the signal from the viewpoint of time series of horizontal scanning, the signals obtained from two kinds of picture elements adjacent in vertical direction are mixed such as (Y+G), (Cy+Ye), (G+W), (Ye+Cy), (W+G) and so on, and taken out in the frequency 7.2MHz as outputs. Decomposing the above mentioned (W+G) and (Cy+Ye) into the components of primary colors r,g and b, it can be understood that both of them consist of r+2g+b. This means that the sampling frequency of the signal Y in horizontal direction is 7.2MHz and, in this imager, high resolution in horizontal direction equivalent to 3.6 MHz which is equal to the frequency in the monochromatic imager can be obtained. Such as this, the two lines simultaneously read out method has such an advantage that, in spite of using many kinds of picture elements such as four, the fundamental sampling frequency for the signal Y can be retained to a short pitch which is equal to the minimum pitch of the picture elements and, due to this fact, high resolution can be attained.

Now, even in the imager by this two lines simultaneously read out method, when, for example, a picture having a pattern in which,as shown in Fig. 7, the boundary between a white part and a black part is sharp on the upper and lower sides of the picture is picked up into an image singal, there may be the case in which the effect of the two lines simultaneously read out method is not exhibited on the boundary and the carrier equevalent to 1.8MHz which is the half of the above arises. Due to this, in the picture displayed on a monitor screen, such phenomenon occur that, for example, lumpy light and shade are visible on the boundary, or the boundary is seen jaggedly. The reason is that, for example, in the case of said boundary being placed just in the middle of the two lines read out simultaneously such as in the middle of the first and second lines, even if the two lines are read out simultaneously, the reading out is essentially equivalent to scanning only one line which is illuminated by light since one of the two is not illuminated entirely or is illuminated dimly. As a result, the carrier which is determined by the repetition period of the reading out of picture elements on one line arises,and in this case, the frequency component of the carrier equal to 1.8MHz arises since the level of each signal, that is W, Cy, G or Ye is different.

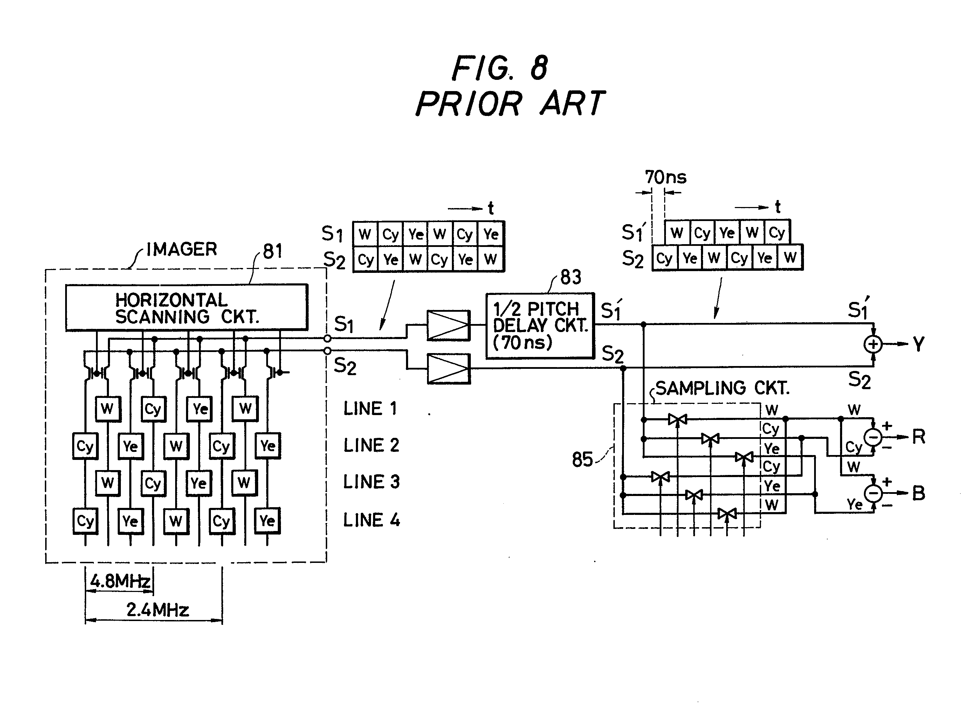

Also, an example using another imager by the two lines simultaneously read out method is shown in Fig. 8. Such an imager has three kinds of picture elements. W,Cy and Ye which are arranged with 1/2 pitch shift in every one line in order to obtaine high horizontal resolution by reading out simultaneously two lines. Such an imaging device is shown, for example, in The Journal of the Institute of Television, Vol 37, No.10 (1983.Oct.) pp.840-846. In Fig. 8, reference numeral 81 denotes a horizontal scanning circuit for reading out the signal of each picture element sequentially in horizontal direction. This circuit corresponds to the horizontal scanning shiftregister 61 in Fig. 6. Reference numeral 83 designates a delay circuit for compensating the time shift which arises due to the simultaneous reading out of two picture elements shifted by 1/2 pitch with each other. After the signals delivered from three kinds of picture elements are separated by 2.4MHz sampling pulses having six phases in the sampling circuit 85, color signals are obtained by an operational processing.

Even in an image pickup device such as this, in the case that a picture of the pattern shown in Fig. 7 is picked up into an image signal, and the boundary between a white part and a black part is placed in the middle of, for example, the first and second lines, the disturbance component whose frequency is 2.4MHz arises due to the same principle as mentioned above, and either "lump" or "jag" appears in this corresponding part of the picture displayed in a monitor TV screen.

SUMMARY OF THE INVENTION

An object of the present invention is to overcome the defect of the conventional TV camera mentioned above and to provide a video signal processing circuit by which reduction or no appearance of the "lump" or "jag" on the boundary can be attained even in the case that there is sharp boundaries between the upper and lower sides of a picture.

The above object can be accomplished by the present invention which provides a video signal processing circuit for a video camera in which the signals of picture elements arranged in the two lines adjacent with each other in vertical direction on an imager are read out during the same horizontal scanning period, comprising: detection means for detecting the vertical edge in a video signal obtained by the imager; and signal restriction means which is arranged in the path of the luminance signal and suppresses the passing of the signal components in a predetermined frequency band in response to the output of the detecting means only when the vertical edge is detected by the detection means.

BRIEF DESCRIPTION OF THE DRAWINGS

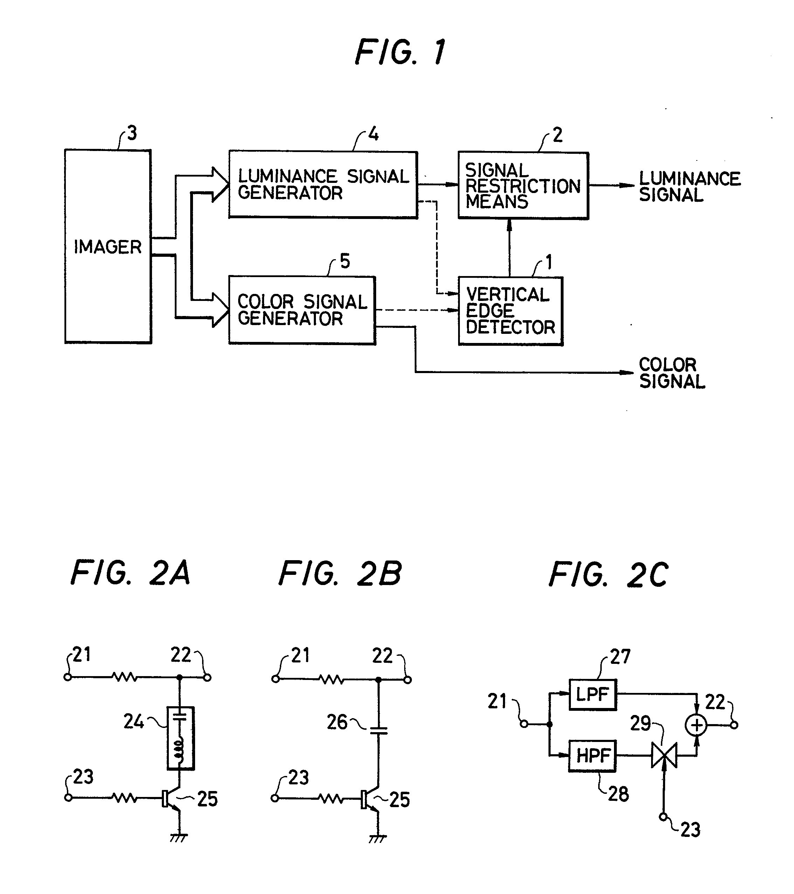

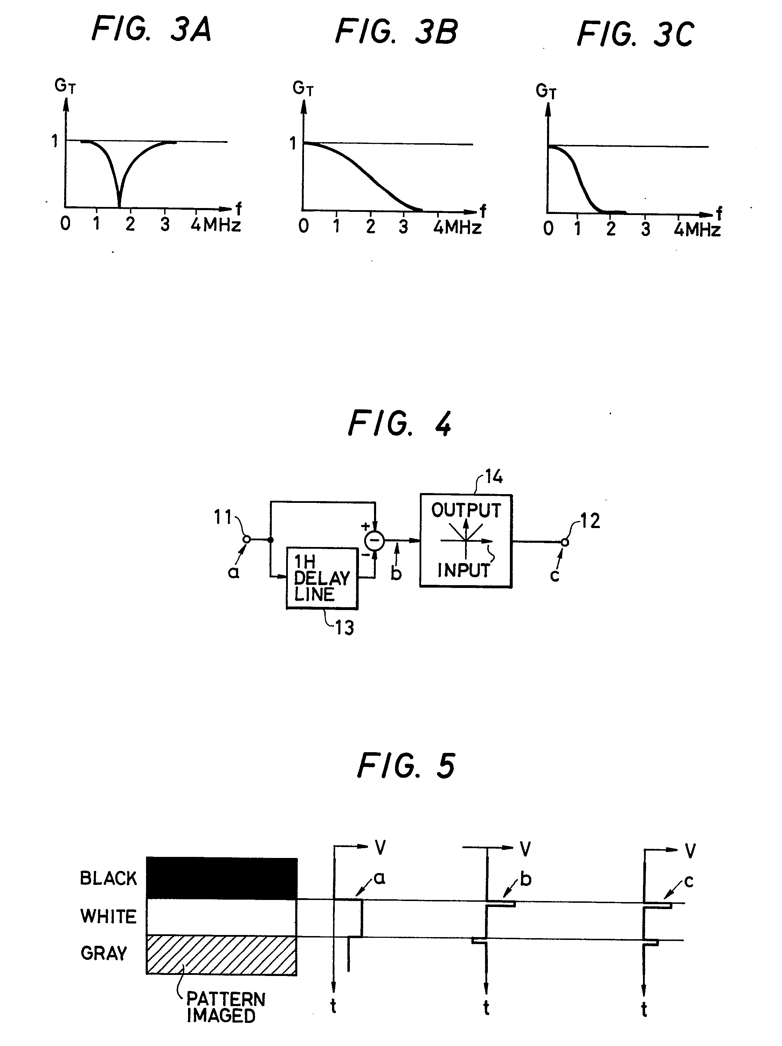

Fig. 1 is a block diagram showing an embodiment of the present invention. Figs. 2A, 2B and 2C are circuit diagrams showing examples of concrete circuits of the signal restriction means for use in the embodiment of the present invention. Figs. 3A, 3B and 3C are the characteristic curves of these circuits for explaining their performance. Fig. 4 is a block diagram showing one example of the vertical edge detection means for use in the embodiment of the present invention. Fig. 5 is an illustration for explaining performance of the vertical edge detection means. Fig. 6 is a block diagram showing an example of the imager to which the two lines simultaneously read out method is applied, and its peripheral circuits. Fig. 7 is an illustrative view for explaining one example of a pattern imaged. Fig. 8 is a block diagram showing another imager wherein the two lines simultaneously read out method is used, and its peripheral circuit.

DETAILED DESCRIPTION OF PREFERRED EMBODIMENTS

Fig. 1 is a block diagram showing an embodiment of the present invention. Reference numeral 3 denotes an imager, 4 a luminance signals generating circuit for generating luminance signals from the output of the imager 3, and 5 a color signal generating circuit for generating color signals also from the output of the imager 3. These circuits are similar to the circuits shown either in Fig. 6 or in Fig. 8. Reference numeral 1 designates a vertical edge detection means for detecting the existence of edges in vertical direction of a picture and reference numeral 2 denotes a signal restriction means for suppressing or limiting the passing of signals whose frequencies are in a predetermined range including the frequency of the above mentioned disturbance component or higher than that of the disturbance component. These two means are the distinctive means in the present invention. The signal restriction means 2, fundamentaly, consists of a filter for suppressing signals whose frequencies are in a specific range and is controlled to have a characteristic of a filter or to pass essentially all signals regardless of their frequencies by a control signal. Accordingly, the performance is so controlled by the output of the vertical edge detection means 1 that the signals whose frequencies are in a specific band or are equal to and higher than a specific frequency is prevented from passing therethrough when the vertical edge is detected and the suppress of the passing ceases when the vertical edge is not detected.

The examples of the concrete construction of such means are explained referring to Figs. 2A to 2C and Figs. 3A to 3C.  In Figs. 2A to 2C, reference numeral 21 denotes a terminal to which output signal to the luminance signal generating circuit 4 is applied and the output signal is obtained at the terminal 22.  The output signal of the vertical edge detection means 1 is applied to the terminal 23.

The circuit shown in Fig. 2A is a band suppress filter for suppressing selectively the passing of signals whose frequencies are in a specific range including the frequency of the disturbance component.  When high level voltage is applied to the terminal 23, the transistor 25 is turned ON and the LC serial resonance circuit 24 forms a resonance trap and, as a result, the frequency characteristic as shown in Fig. 3A is obtained.  This trap frequency is selected to 1.8MHz in the case of such imager as shown in Fig. 6, and is selected to 2.4MHz in the case of such imager as shown in Fig. 8.  In the circuit shown in Fig. 2A, since it is possible to pass signals whose frequencies are higher than the trap frequency even in the case that the trap is in function, the deterioration of the vertical resolution can be minimized even in the part of the vertical edge.

The circuit shown in Fig. 2B is a circuit for suppressing the passing of signals whose frequencies are higher than the frequency of the disturbance component and this circuit gives the characteristic of a low pass filter owing to the capacitor 26 functioned by turnning transistor 25 ON. The special feature of this circuit is its simplicity of the construction, but there is such a problem that it is difficult to obtain enough ability of suppressing of signals in the frequency of the disturbance component (in this case, it is 1.8MHz) as the frequency characteristic shown in Fig. 3B.

The circuit shown in Fig. 2C is one example of circuits by which the passing of signals whose frequencies are equal to and higher than that of the disturbance component can be suppressed enough. This circuit separates the input signal to low and high frequency components by the low pass filter 27 and the high pass filter 28 respectively and controls the passing of high frequency components including the frequency of the disturbance component by the ON-OFF of the analog gate 29. As is shown in Fig. 3C, better effect of suppressing of the disturbance than that shown in Fig. 3B can be obtained by the selection of the cut-off characteristics of the low pass filter 27 and the high pass filter 28.

The examples shown in Figs. 3A to 3C are the characteristics of these circuits which are applied to the case that the frequency of the disturbance component is 1.8MHz and, since the frequency of the disturbance component varies when the arrangement of picture elements of the imager is changed, it is necessary to change the setting of frequency in these circuits according to the imager used. For example, in the case of using such imager as shown in Fig. 8, the frequency is set to 2.4MHz as above mentioned.

In the next, an example of the concrete construction of the vertical edge detection means 1 is shown in Fig. 4 and its performance is explained in Fig. 5. In Fig. 4, reference numeral 11 designates an input terminal for the video signal, 12 an output terminal for the detected signal of the existence of the vertical edge, 13 a delay circuit with the delay time equal to one horizontal scanning period (1H), and 14 an absolute value circuit consisting of, for example, a full-wave rectifier.

It has been well known that the vertical edge signal is extracted by subtracting the signal delayed for the time 1H from the signal not delayed. Fig. 5 shows signal waveforms corresponding to the illustrated image pattern of white, black and gray colors. In this figure, symbol a denotes a waveform of the video signal appearing at the terminal 11, which is shown corresponding to the image pattern, b designates a waveform of the output of the subtracting operation, which becomes pulse signal whose porlarity is opposite according to the direction of the variation of the luminance at a boundary. By letting this signal pass through the absolute valve circuit 14, the signal C corresponding to a sharp boundary between the upper and lower parts of a picture, that is to a vertical edge part is obtained at the terminal 12. Since the passing of the disturbance component arising at the vertical edge can be suppressed by applying this signal C to the control signal terminal 23 in the signal restriction means 2, it is possible to eliminate the disturbance.

The luminance signal is generally proper as the video signal applied to the input terminal 11 of the circuit shown in Fig. 4, but it is possible to use color signals such as red (R), green (G), and blue (B) color signals and further it is possible to use color difference signals such as (R-Y), (B-Y), and so on. In such cases, characteristic detections of the vertical edge are possible respectively. For example, not in the case of the pattern colored as shown in Fig. 7 but in the case of a pattern colored by magenta and green colors adjarcent with each other at the upper and lower sides of a picture, the vertical edge can not be detected well by these luminance signals since the difference of these luminance levels is small, but if the color difference signal is used, the vertical edge of such case as above mentioned can be detected sharply since (R-Y) varies largely from positive to negative at the boundary of two colors. Accordingly, by providing a circuit for detecting vertical edges using color signals in addition to the vertical edge detection circuit using luminance signals and making the signal restriction means operative when at least one of the two circuits detects a vertical edge, it becomes more effective to eliminate the disturbance.

In the next, another concrete example of the vertical edge detection means will be explained without figures. In this example, a vertical edge is detected by subtracting the signal of one line from the signal of the other line obtained from the imager by the two lines simultaneously read out method as shown in Fig. 6 and Fig. 8. However, in the case of the imager shown in Fig. 6, since signals delivered from two lines are given to each signal line of W, Ye, Cy and G alternately, these signals must be separated to the signal corresponding to each by sampling. The detail of the technique for detecting a vertical edge directly such as this from the output of an imager is described, for example, in the official gazette of Japanese Patent Application Laid-Open No. 143675/1983 and it can be used for the present invention.

As above mentioned, according to the present invention, the disturbance showing "lump" or "jag" at the boundary arising when a object having a sharp boundary of a pattern between the upper and lower sides is picked up by an imager wherein the two lines simultaneously read out method is applied thereto, can be eliminated or reduced and the quality of pictures can be improved largely.

And since the suppressing filter for suppressing or restricting the passing of signals operates to suppress the passing of signals only when said boundary part between the upper and lower sides is scanned, the passing

0 173 306

frequency of the luminance signals is not varied except on this boundary part and as a result, the deterioration of the horizontal resolution does not occur except on the boundary part.

- 1 -                                    **0 173 306**

## C l a i m s

1. A video signal processing circuit for a video camera in which the signals of picture elements arranged in the two lines adjacent with each other in vertical direction on an imager are read out during the same horizontal scanning period, comprising:

detection means for detecting the vertical edge in a video signal obtained by the imager; and

a signal restriction means which is arranged in the path of the luminance signal and suppresses the passing of the signal components in a predetermined frequency band in response to the output of the detection means only when the vertical edge is detected by the detection means.

2. A circuit according to claim 1, wherein said detection means detects the vertical edges from the luminance signal.

3. A circuit according to claim 1, wherein said detection means detects the vertical edges from the luminance signal and the color difference signal respectively and said signal restriction means is controlled by at least one of the results of both detections.

4. A circuit according to claim 1, wherein said restriction means has the high suppress characteristic in which the passing of signal components whose frequencies are equal to and higher than a predetermined frequency are suppressed or restricted.

5.  A circuit according to claim 2, wherein said restriction means has the high suppress characteristic in which the passing of signal componetns whose frequencies are equal to and higher than a predetermined frequency are suppressed or restricted.

6.  A circuit according to claim 3, wherein said restriction means has the high suppress characteristic in which the passing of signal components whose frequencies are equal to and higher than a predetermined frequency are suppressed or restriceted.

7.  A circuit according to claim 1, wherein said detection means detects the vertical edges from the difference between the signals which are read out during the same horizontal scanning period from the picture elements arranged in the two lines adjacent with each other in vertical direction on the imager.

## FIG. 1

## FIG. 2A    FIG. 2B    FIG. 2C

## FIG. 3A

## FIG. 3B

## FIG. 3C

## FIG. 4

## FIG. 5

## FIG. 6
## PRIOR ART

61

HORIZONTAL SHIFT
REGISTER (7.2MHz)

W
Ye
G   Cy

LUMINANCE
SIGNAL (Y)

VERTICAL SHIFT REGISTER

INTERLACING CKT

| W | Cy | G | Ye | LINE 1 |

| G | Ye | W | Cy | LINE 2 |

| W | Cy | G | Ye | LINE 3 |

7.2MHz

3.6MHz

62    63

RED COLOR
SIGNAL (R)

BLUE COLOR
SIGNAL (B)

## FIG. 7

BLACK

WHITE

GRAY

0 173 306

# FIG. 8
## PRIOR ART

**European Patent Office**

## EUROPEAN SEARCH REPORT

| | DOCUMENTS CONSIDERED TO BE RELEVANT | | EP 85110810.0 |
|---|---|---|---|

| Category | Citation of document with indication, where appropriate, of relevant passages | Relevant to claim | CLASSIFICATION OF THE APPLICATION (Int. Cl.4) |
|---|---|---|---|
| A | GB - A - 2 000 937 (EASTMAN KODAK) -- | | H 04 N 5/14 H 04 N 9/64 |
| A | GB - A - 2 005 511 (SONY) ---- | | |

**TECHNICAL FIELDS SEARCHED (Int. Cl.4)**

H 04 N 3/00

H 04 N 5/00

H 04 N 9/00

The present search report has been drawn up for all claims

| Place of search | Date of completion of the search | Examiner |
|---|---|---|
| VIENNA | 22-10-1985 | BENISCHKA |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82